# FASCICULE DE BREVET EUROPEEN

(11) **EP 2 876 677 B1**
(45) Date de publication et mention de la délivrance du brevet: **18.09.2019**
(21) Numéro de dépôt: 14194662.4
(22) Date de dépôt: 25.11.2014
(51) Int. Cl.: H01L 21/02, H01L 21/8234, H01L 29/66, H01L 29/78, H01L 21/84, H01L 29/417

(54) **Procédé de formation des espaceurs d'une grille d'un transistor**
Verfahren zur Bildung von Abstandhaltern eines Gates eines Transistors
Method for forming spacers of a transistor gate

(30) Priorité: 25.11.2013 FR 1361585
(43) Date de publication de la demande: 27.05.2015
(73) Titulaire: COMMISSARIAT À L'ÉNERGIE ATOMIQUE ET AUX ÉNERGIES ALTERNATIVES, 75015 Paris (FR)
(72) Inventeur: POSSEME, Nicolas, 38000 GRENOBLE (FR)
(74) Mandataire: Hautier, Nicolas

(56) Documents cités:
- GB-A- 2 362 029
- US-A1- 2004 087 155
- US-A1- 2008 272 445
- US-A1- 2013 164 940
- US-B1- 6 255 219
- US-B1- 6 380 030

## Description

### DOMAINE TECHNIQUE DE L'INVENTION

La présente invention concerne en général les transistors à effet de champs (FET) utilisés par l'industrie de la microélectronique et plus particulièrement la réalisation des espaceurs de grille des transistors de type métal-oxyde-semiconducteur (MOSFET) majoritairement utilisés pour la production de toutes sortes de circuits intégrés.

### ÉTAT DE LA TECHNIQUE

La course incessante à la réduction des dimensions qui caractérise toute l'industrie de la microélectronique n'a pu se faire qu'avec l'apport d'innovations clés tout au long de décennies de développement depuis que les premiers circuits intégrés ont été produits industriellement dans les années soixante. Une innovation très importante qui remonte aux années soixante-dix, et qui est toujours utilisée, consiste à réaliser les transistors MOSFET à l'aide d'une technique dans laquelle les électrodes de source et de drain sont auto alignés sur celles de grille et ne nécessitent donc pas d'opération de photogravure pour leur définition. Combiné avec l'utilisation de grilles en silicium polycristallin, ce sont les grilles elles-mêmes, réalisées en premier, qui servent de masque lors du dopage des zones de source et drain des transistors.

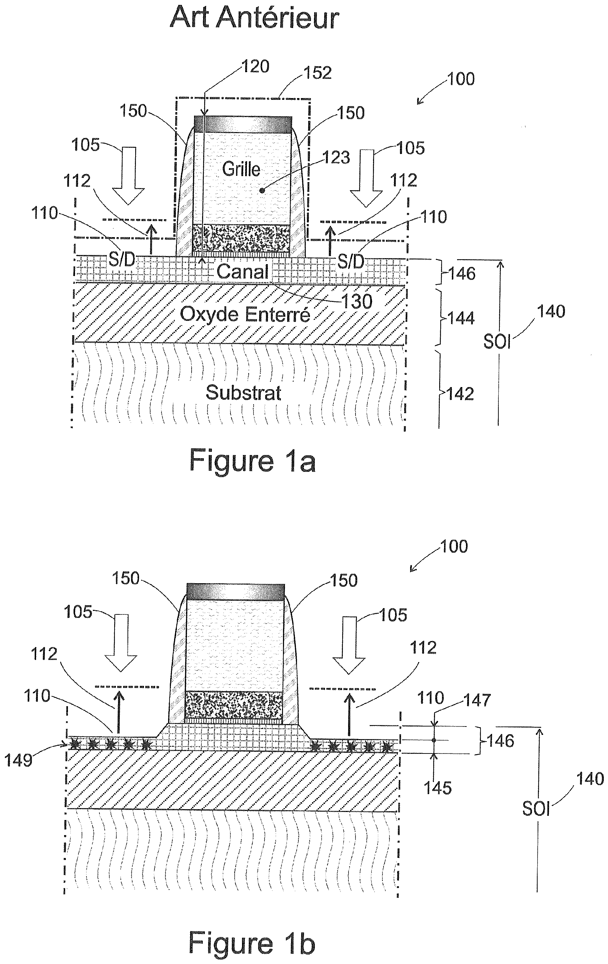

La **figure 1a** est une vue en coupe d'un exemple de ce type de transistor 100 en cours de réalisation. On y retrouve les zones de source et de drain 110, globalement désignées zones source/drain, puisqu'elles sont très généralement parfaitement symétriques et peuvent jouer les deux rôles en fonction des polarisations électriques qui sont appliquées au transistor. La grille est classiquement constituée d'un empilement de couches 120 dont une grande partie est toujours constituée de silicium polycristallin 123. La formation des zones de source et drain se fait typiquement par implantation ionique 105 de dopants dans les zones 110, la grille 120 servant de masque comme mentionné ci-dessus, empêchant ainsi le dopage de la zone du transistor MOSFET dans laquelle, en fonction des tensions appliquées sur la grille, va pouvoir se développer le canal 130 de conduction entre source et drain.

La technique de base, très brièvement décrite ci-dessus, bien connue de l'homme du métier ainsi que de nombreuses variantes, a été constamment perfectionnée dans le but d'améliorer les performances électriques des transistors tout en permettant d'accommoder les réductions de taille successives des transistors nécessitées par une intégration toujours croissante d'un plus grand nombre de composants dans un circuit intégré.

Une technique largement utilisée actuellement consiste à fabriquer les circuits intégrés en partant de substrats élaborés 140 de type silicium sur isolant, désignés par leur acronyme SOI, de l'anglais « silicon on insulator ». Le substrat élaboré SOI est caractérisé par la présence d'une fine couche superficielle de silicium monocristallin 146 reposant sur une couche continue d'oxyde de silicium 144, dit oxyde enterré ou encore BOX, acronyme de l'anglais « buried oxide layer ». La solidité et la rigidité mécanique de l'ensemble sont assurées par la couche 142 qui constitue le corps du substrat SOI, souvent qualifié du vocable anglais de « bulk » pour indiquer que le substrat de départ est très généralement fait de silicium massif. Cette structure offre de nombreux avantages pour la réalisation des transistors MOSFET. Notamment, elle permet une réduction drastique des capacités parasites en raison de la présence de la couche continue isolante 144. En ce qui concerne l'invention, on retiendra seulement que la couche superficielle de silicium monocristallin 146 peut être contrôlée précisément en épaisseur et en dopage. En particulier, il est avantageux pour les performances des transistors que le canal 130 puisse être complètement déserté de porteurs, c'est-à-dire « fully depleted » (FD), vocable anglais qui est généralement utilisé pour désigner cet état. Ceci est obtenu en réalisant les transistors à partir de substrats SOI dont la couche superficielle 146 est très mince ce qui n'est pas sans inconvénient par ailleurs comme on le verra dans la description de l'invention. Ce type de transistor est ainsi désigné par l'acronyme FDSOI.

Un perfectionnement de la technique de base d'auto alignement qui a été universellement adopté consiste en la formation d'espaceurs 150 sur les flancs de la grille. Les espaceurs 150, typiquement faits de nitrure de silicium (SiN), vont permettre en particulier la mise en oeuvre d'une technique dite de « Source et Drain surélevés ». Pour pouvoir maintenir de faibles résistances électriques d'accès aux électrodes de source et de drain, en dépit de la réduction de taille des transistors, il a fallu en effet augmenter leur section. Ceci est obtenu par épitaxie sélective des zones source/drain 110. Au cours de cette opération on va faire croître 112 localement la couche initiale de silicium monocristallin 146. Il faut alors protéger les zones de grilles pour empêcher la croissance de se faire également à partir du silicium polycristallin 123 de la grille. C'est, entre autres, le rôle des espaceurs que d'assurer cette fonction. Ils assurent également un rôle de préservation de la grille lors de la siliciuration des contacts (non représentée) qui est ensuite effectuée dans le même but afin de diminuer la résistance série d'accès aux électrodes du transistor.

La formation des espaceurs 150 est devenue une étape cruciale de formation des transistors qui atteignent désormais des dimensions qui se mesurent couramment en nanomètres (nm = 10⁻⁹ mètres) et qui sont globalement de tailles décananométriques. La réalisation des espaceurs se fait sans faire intervenir aucune opération de photogravure. Ils sont auto alignés sur la grille 120 à partir du dépôt d'une couche uniforme de nitrure de silicium 152 (SiN) qui subit ensuite une gravure très fortement anisotrope. Cette gravure du SiN attaque préférentiellement les surfaces horizontales, c'est-à-dire toutes les surfaces qui sont parallèles au plan du substrat SOI. Elle ne laisse en place, imparfaitement, que les parties verticales de la couche 152, celles sensiblement perpendiculaires au plan du substrat, afin d'obtenir en pratique les motifs 150 dont la forme idéale serait évidemment rectangulaire.

Avec les solutions connues, la réduction de taille des transistors rend très délicate l'obtention d'espaceurs jouant pleinement leur rôle d'isolation et n'induisant pas de défauts dans la réalisation de transistors à partir de substrats SOI. En effet, dans le cadre de la présente invention, et comme cela sera détaillé par la suite, il a été constaté que plusieurs types de défaut tels que ceux mentionnés ci-dessous apparaissent lors de la gravure des espaceurs en utilisant l'un ou l'autre des procédés connus de gravure anisotrope.

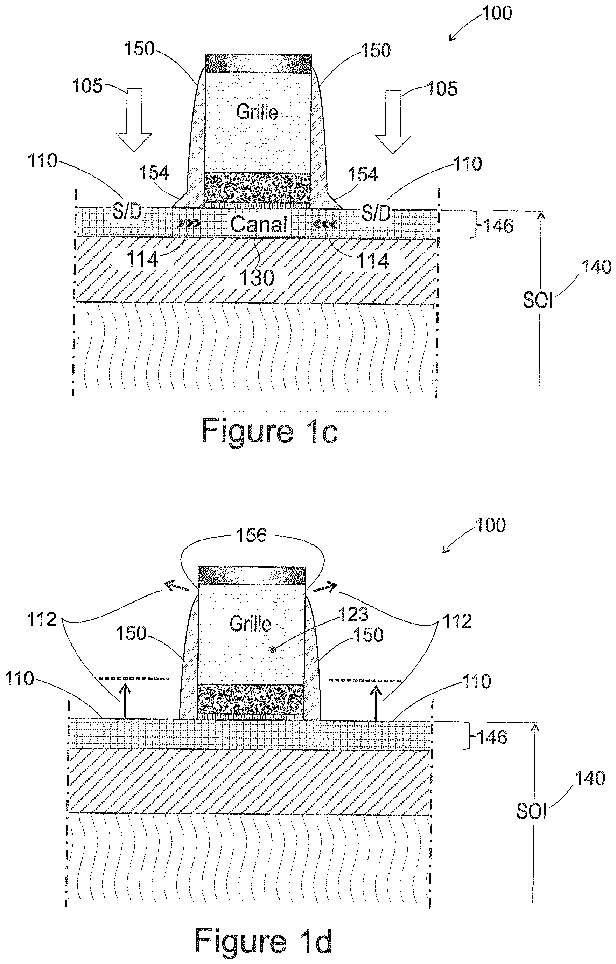

Les **figures 1b****,** **1c et 1d** illustrent chacune un type de défaut observé.

On utilise notamment un type de gravure qui est dite « sèche » et qui se met en oeuvre à l'aide d'un procédé qui est le plus souvent désigné par son acronyme RIE, de l'anglais « reactive-ion eching », c'est-à-dire : « gravure ionique réactive ». Il s'agit d'un procédé de gravure dans lequel on forme, dans une enceinte confinée, un plasma qui réagit physiquement et chimiquement avec la surface de la tranche à graver. Dans le cas de la gravure d'une couche de nitrure de silicium, qui est comme on l'a vu le matériau préféré pour la réalisation des espaceurs, le gaz réactif est typiquement le fluorure de méthyle (CH3F) que l'on fait réagir avec le matériau à graver en introduisant également du dioxygène (O2) et possiblement de l'hélium (He). On forme ainsi un plasma de gravure basé sur la chimie du fluor et souvent désigné par ses constituants : CH3F/O2/He. Dans ce plasma le composé fluor sert à graver le nitrure de silicium tandis que l'oxygène permet de limiter la polymérisation du fluorure de méthyle et sert également à oxyder le silicium lorsque ce matériau est atteint en cours de gravure. La couche d'oxyde formée sur le silicium permet de ralentir la gravure du silicium au prix cependant d'une transformation en surface de ce dernier en oxyde et donc d'une consommation superficielle de silicium. L'hélium sert de diluant pour l'oxygène. D'autres gaz réactifs ont été expérimentés comme le méthane (CH4) et l'hexafluorure de soufre (SF6).

L'avantage de ce type de gravure est qu'elle est assez anisotrope et permet de contrôler suffisamment le profil des espaceurs 150 même si l'on ne peut pas obtenir en pratique la forme rectangulaire idéale. L'inconvénient de ce type de gravure est que la sélectivité d'attaque du silicium sous-jacent est cependant limitée. La sélectivité, c'est-à-dire le rapport des vitesses de gravure entre le nitrure de silicium et le silicium est de l'ordre de 10 et peut atteindre 15 au maximum en fonction des conditions de formation du plasma (le nitrure est gravé 10 à 15 fois plus vite que le silicium).

On utilise aussi des gravures dites « humides » à base d'acide fluorhydrique (HF) ou d'acide phosphorique (H3PO4) qui ont une bien meilleure sélectivité, respectivement, vis-à-vis du silicium ou de son oxyde (SiO2) mais qui ne permettent pas cependant de contrôler le profil des espaceurs puisque la gravure est essentiellement isotrope dans ce cas. On notera ici que ce type de gravure est aussi qualifié de « nettoyage humide » traduction de l'anglais « wet clean ».

On notera ici qu'il existe de nombreuses publications sur le sujet de la gravure du nitrure de silicium et/ou des espaceurs de grille en général. On pourra se référer par exemple aux brevets ou demandes de brevets américains suivants : 2003/0207585 ; 4 529 476 ; 5 786 276 et 7 288 482.

La **figure 1b** illustre un premier problème qui est en relation avec la sélectivité insuffisante d'attaque qui existe lors d'une gravure sèche de type CH3F/O2/He entre le nitrure de silicium et le silicium de la couche superficielle 146. Le résultat est qu'une fraction significative de la mince couche superficielle de silicium monocristallin 146 du substrat SOI peut être alors partiellement consommée 147 lors de la gravure anisotrope du nitrure. Comme précédemment mentionné, la couche superficielle 146 est choisie pour être de faible épaisseur afin d'améliorer les caractéristiques électriques des transistors. Elle est typiquement inférieure à 10 nm. L'épaisseur restante 145 peut être très faible. Dans ces conditions l'implantation ionique 105 pour former les zones de source et de drain 110 qui va suivre est susceptible d'être très dommageable pour le silicium monocristallin restant. L'énergie d'implantation des dopants peut être suffisante pour provoquer une amorphisation complète 149 du silicium monocristallin ce qui va alors notamment compromettre l'étape de croissance épitaxiale 112 suivante destinée à former les source/drain surélevés. Comme précédemment mentionné, cette dernière opération est rendue nécessaire en raison de la diminution de taille des transistors afin de pouvoir maintenir les résistances d'accès aux électrodes de source et de drain à des valeurs suffisamment faibles pour ne pas impacter le fonctionnement électrique des transistors. Une croissance à partir d'une couche de silicium partiellement ou totalement rendue amorphe va créer de nombreux défauts dans la couche formée par épitaxie.

La **figure 1c** illustre un autre problème où il n'y a pas consommation significative du silicium de la couche superficielle 146 mais il y a formation de « pieds » 154 au bas des motifs de nitrure de silicium restants sur les flancs de la grille après gravure. La conséquence est que la transition 114 des jonctions qui sont formées après dopage par implantation ionique 105 des zones de source et drain 110, avec la zone du canal 130, est beaucoup moins abrupte que lorsque les espaceurs n'ont pas de pieds comme représenté dans les figures précédentes. La présence de pieds 154 affecte les caractéristiques électriques des transistors. On remarquera ici que la formation ou non de pieds au bas des espaceurs et la consommation ou non de silicium de la couche superficiel de silicium 146 du substrat SOI, décrite dans la figure précédente, sont des paramètres de réglage antagonistes de la gravure qui nécessitent qu'un compromis puisse être trouvé pour lequel, idéalement, on ne forme pas de pieds et on n'attaque pas significativement la couche superficielle de silicium.

La **figure 1d** illustre un troisième problème qui se produit quand la gravure produit une érosion trop importante des espaceurs dans les parties hautes des grilles et met à nu le silicium polycristallin 123 dans ces zones 156. La conséquence est que la croissance épitaxiale 112 ultérieure pour former les source/drain surélevés va aussi se produire à ces endroits, ainsi qu'une siliciuration de contacts parasites, ce qui risque de provoquer des courts circuits entre électrodes. En effet, la gravure des espaceurs demande que le temps de gravure soit ajusté pour graver, par exemple, 150% de l'épaisseur de nitrure déposé. C'est-à-dire que l'on pratique une surgravure de 50% dans cet exemple afin de tenir compte de la non uniformité du dépôt, ou de l'opération de gravure elle-même, au niveau d'une tranche. Ainsi, dans certaines parties de la tranche on pourra constater qu'il y a une surgravure trop prononcée qui met à nu les zones de grille 156. Ce type de défaut est aussi qualifié de « facettage ».

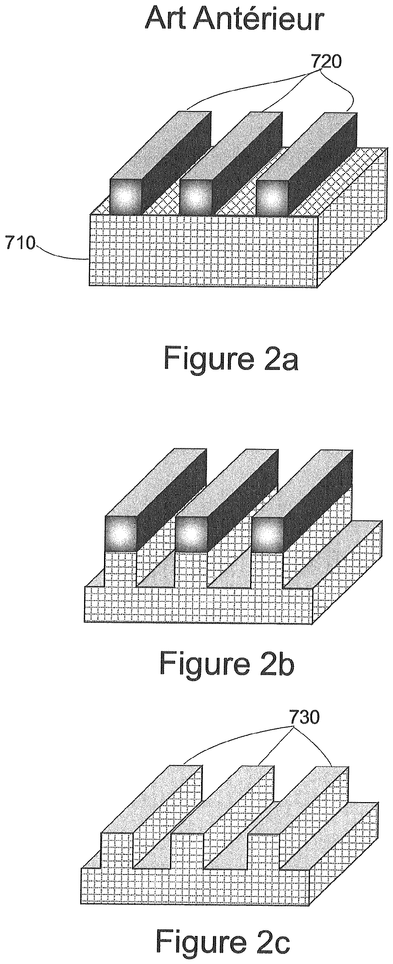

Les **figures 2a à 2i** illustrent comment les problèmes liés à la gravure plasma se posent plus spécifiquement lors de la réalisation de transistors MOSFET de type FinFET, une autre structure de transistor qui commence à être utilisée par l'industrie de la microélectronique pour les noeuds technologiques à partir de celui de 22 nm. Dans la structure FinFET le canal de conduction est constitué d'une mince lamelle verticale de silicium, qualifiée du terme anglais de « fin » c'est-à-dire de « nageoire ». Il est entouré sur trois côtés par la grille de commande. Cela permet notamment d'obtenir des transistors ayant de meilleures performances électriques et aussi de réduire les courants de fuite.

Les figures **2a à 2i** décrivent les étapes principales de formation d'un transistor FinFET et les difficultés rencontrées. Les **figures 2a, 2b et 2c** illustrent plus particulièrement la formation par gravure d'une couche 710 d'un semi-conducteur cristallin, le plus souvent du silicium, des motifs tridimensionnels, c'est-à-dire les « fins », qui vont former les canaux de conduction 730 des transistors. La forme des canaux est définie par un masque dur 720 qui est transféré par gravure dans la couche 710. Cette couche est par exemple la couche superficielle de silicium monocristallin d'un substrat SOI déjà décrit et repose donc sur une couche continue d'oxyde et un substrat (non représentés).

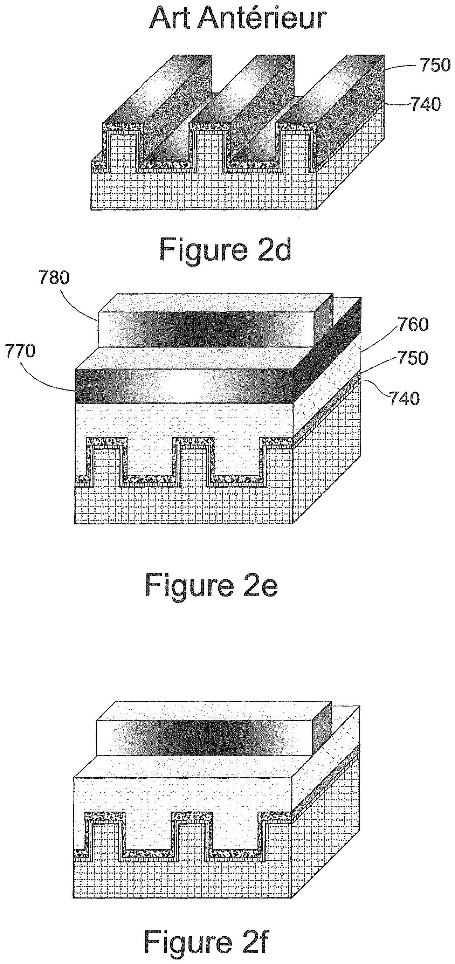

Les **figures 2d, 2e et 2f** illustrent la formation de la grille des transistors. Comme avec les transistors de type FDSOI la grille est constituée d'un empilement de couches que l'on vient successivement déposer sur les motifs 730 qui vont constituer les canaux. On retrouve donc la fine couche isolante d'oxyde de grille 740 et la couche 750 faite d'un matériau isolant à haute permittivité (high-k) couverte par une grille métallique (metal gate). Le tout est recouvert par une couche de silicium polycristallin 760 qui a été aplanie et sur laquelle on dépose et définit par photolithographie les masques durs 770 et 780 qui vont permettre par gravure de l'empilement des couches ci-dessus de former la grille ainsi que les électrodes source et drain des transistors.

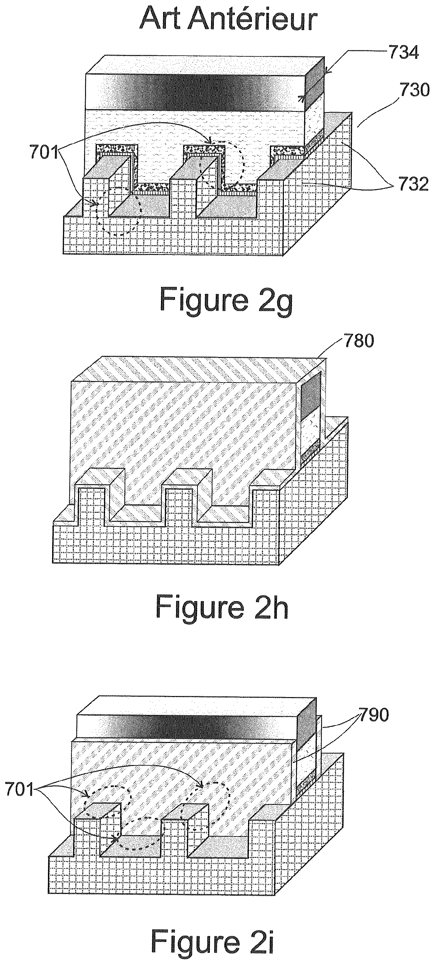

Les **figures 2g, 2h et 2i** illustrent les opérations suivantes où l'on procède à la gravure des couches de grille ce qui permet de libérer, à partir de chaque motif 730, les zones de source et de drain 732 de part et d'autre de la grille et de définir la longueur des canaux 734. Comme avec les transistors de type FDSOI on a aussi besoin d'espaceurs. Ils sont obtenus, après dépôt d'une couche continue 780 faite généralement de nitrure de silicium, à l'aide d'une gravure très anisotrope de cette couche qui ne laisse en place que les motifs verticaux 790 sur les flancs de la grille.

Comme les transistors FDSOI, les transistors de type FinFET souffrent donc pour leur réalisation des limitations et imperfections de la gravure plasma. En particulier, pour réaliser cette structure de transistor, la gravure utilisée doit avoir une excellente sélectivité vis-à-vis du silicium (Si) et de son oxyde (SiO2) ce qui est difficile à obtenir, comme on l'a vu, avec une gravure plasma. Comme indiqué sur les **figures 2g et 2i** l'intégrité des angles des motifs gravés en est affectée. En effet, pour que le transistor FinFET présente de bonnes performances, les arêtes 701 des « fins » doivent former des angles qui soient les plus droits possible, tout arrondi de ces angles entraînant une réduction des performances du transistor. Il en est de même pour l'angle que forme les espaceurs et la couche sur laquelle elle repose, typiquement la couche de silicium. Cet angle est indiqué en pointillé sur la **figure 2i****.**

Pour les raisons indiquées ci-dessus, les solutions actuelles reposant sur les gravures plasma ne permettent pas d'obtenir des arêtes formant des angles droits.

On voit donc que la gravure plasma, si elle a permis de suivre les réductions de taille des motifs à chaque introduction d'un nouveau noeud technologique dans les années passées, pose cependant de plus en plus de problèmes quand la taille diminue, en particulier au-delà du noeud technologique de 22 nm. La mise en oeuvre de la gravure plasma pour ces dimensions introduit un degré de complexité supplémentaire pour essayer de pallier les problèmes décrits ci-dessus. Des chimies de gravure plus complexes que celle traditionnelle, dite fluorocarbonée, ont été testées qui nécessitent d'introduire des gaz supplémentaires dans la chambre de gravure. Jusqu'à cinq gaz différents ont été combinés pour former le plasma de gravure. Cela a pour conséquence première de complexifier considérablement le procédé.

Le caractère tridimensionnel (3D) de la structure FinFET fait que les problèmes exposés précédemment pour la réalisation des transistors de type FDSOI se posent avec encore plus d'acuité pour la réalisation des FinFET. On notera par ailleurs que la réalisation de cette structure demande que l'on ait recours non seulement à une gravure anisotrope pour la réalisation des espaceurs 790 sur les flancs des électrodes de grille mais que l'on puisse également graver les flancs des électrodes source/drain 732 en ayant recours à une gravure isotrope.

Il est connu de GB 2 362 029 A et US 2008/272445 A1 la réalisation d'espaceurs comprenant une pluralité de sous-espaceurs dont au moins un comprenant une couche poreuse. US 2004/087155 A1 divulgue l'implantation d'ions au niveau des espaceurs lors d'étapes de gravure pour retirer entièrement ces espaceurs.
La présente invention a pour objet de proposer un procédé de formation d'espaceurs jouant pleinement leur rôle d'isolation et qui supprimerait ou limiterait les défauts dans la réalisation de transistors.
Les autres objets, caractéristiques et avantages de la présente invention apparaîtront à l'examen de la description suivante et des dessins d'accompagnement. Il est entendu que d'autres avantages peuvent être incorporés.

### RÉSUMÉ DE L'INVENTION

Pour atteindre cet objectif, un aspect de la présente invention concerne un procédé de formation des espaceurs d'une grille d'un transistor à effet de champ, la grille étant située au-dessus d'une couche active en un matériau semi-conducteur, le procédé comprenant une étape de formation d'une couche de protection recouvrant au moins la grille du transistor; le procédé comprenant en outre une étape de formation d'une couche poreuse, une étape de gravure de la couche de protection, une modification de la couche poreuse pour former une couche modifiée, et une étape de retrait de la couche modifiée.

L'étape de formation de la couche poreuse est réalisée avant l'étape de formation de la couche de protection. La couche poreuse obtenue est située entre la grille et la couche de protection et présente une constante diélectrique k égale ou inférieure à celle de l'oxyde de silicium (Si02). Ensuite, l'étape de gravure de la couche de protection est réalisée de manière anisotrope de sorte à conserver des portions résiduelles de la couche de protection uniquement au niveau des flancs de la grille, ces portions résiduelles constituant des espaceurs de protection de la grille. Une modification de la couche poreuse est effectuée de manière anisotrope par pénétration d'ions issus d'un plasma au sein de la couche poreuse. La couche modifiée est obtenue en modifiant la couche poreuse sur toute son épaisseur au-dessus de la grille et au-dessus de la couche active et de sorte à ne pas modifier toute l'épaisseur de la couche poreuse située sur les flancs de la grille. La couche poreuse située sur les flancs de la grille est en effet protégée par les espaceurs de protection. La couche poreuse qui demeure sur les flancs de la grille constitue des espaceurs poreux pour la grille. L'étape de retrait de la couche modifiée est ensuite effectuée de manière à laisser en place les espaceurs de protection, en réalisant une gravure sélective de la couche modifiée vis-à-vis dudit matériau semi-conducteur de la couche active.

La combinaison de deux couches d'espaceurs, l'une (couche de protection) de préférence en nitrure, l'autre en un diélectrique poreux à faible constante diélectrique, permet d'améliorer les performances des transistors tout en limitant l'apparition des problèmes évoqués précédemment.

En effet, le diélectrique poreux, une fois modifiée par les ions du plasma, est consommé très facilement et avec une sélectivité vis-à-vis du matériau semi-conducteur de la couche active (typiquement du silicium), bien supérieure à la sélectivité des espaceurs de nitrure SiN (ou Si3N4) habituellement utilisés par rapport au Si comme le prévoit les solutions connus. En effet, les solutions connues prévoit une solution de gravure à base d'acide fluorhydrique (HF) qui consomme le nitrure à une vitesse de 0.5 nm/minute et avec une sélectivité du nitrure par rapport au silicium de l'ordre de 20 à 30. Avec l'invention, la sélectivité de la couche poreuse modifiée par exemple de SiOCH poreux par rapport au Si est supérieure à 100. Cela permet donc d'améliorer considérablement la sélectivité et donc la précision de la gravure.

On évite ainsi de consommer de manière excessive la couche active, de découvrir les flancs de la grille ou de former des pieds. En outre, lors de l'injection des ions du plasma et lors du retrait de la couche poreuse située en dehors des flancs de la grille, les espaceurs de protection protègent la couche poreuse recouvrant les flancs. Cette dernière n'est donc pas altérée par l'injection des ions et demeure en place. Le contrôle du dimensionnel est donc amélioré par rapport à une solution sans couche de protection en nitrure.

La constante diélectrique d'un transistor selon l'invention est particulièrement faible ce qui permet d'améliorer les performances du transistor.

Notamment, la capacité réduite du transistor selon l'invention permet d'augmenter sa vitesse de fonctionnement et de réduire sa consommation électrique.

Selon l'invention, la modification de la couche poreuse est réalisée par implantation d'ions dans la couche poreuse à partir d'un plasma comprenant lesdits ions.

L'implantation par plasma a pour avantage de permettre une implantation de manière continue dans un volume s'étendant dès la surface de la couche implantée.

En outre l'utilisation d'un plasma permet une implantation à des profondeurs plus faibles que les profondeurs minimales que l'on peut obtenir avec des implanteurs. Ainsi, une implantation par plasma permet d'implanter efficacement et de manière relativement homogène ou tout au moins de manière continue des épaisseurs fines que l'on peut ensuite retirer par une gravure sélective. Cette continuité d'implantation depuis la face implantée permet d'améliorer l'homogénéité de la modification selon la profondeur, ce qui conduit à une vitesse de gravure constante dans le temps de la couche implantée. Par ailleurs, l'augmentation de la sélectivité conférée par l'implantation vis à vis des autres couches est effective dès le début de la gravure de la couche implantée. L'implantation par plasma permet ainsi un contrôle significativement amélioré de la précision de gravure.

L'implantation plasma permet typiquement d'implanter puis de retirer des épaisseurs s'étendant depuis la surface de la couche implantée et sur une profondeur allant de 0 nm à 100nm. Les implanteurs classiques, permettent une implantation dans un volume compris entre 30 nm et plusieurs centaines de nanomètres. En revanche, les implanteurs classiques ne permettent pas d'implanter les espèces entre la surface de la couche à implanter et une profondeur de 30nm. Dans le cadre du développement de la présente invention, il a été remarqué que les implanteurs ne permettent alors pas d'obtenir une vitesse de gravure suffisamment constante de la couche modifiée et ce depuis la surface de cette dernière, conduisant ainsi à une moindre précision de gravure comparé à ce que permet l'invention. Par ailleurs, l'utilisation d'un plasma pour modifier la couche permet de ne pas modifier la couche active située sous la couche poreuse.

L'utilisation d'un plasma pour modifier la couche à retirer est donc particulièrement avantageuse dans le cadre de l'invention qui vise à retirer une fine épaisseur de couche poreuse, typiquement comprise entre 1 et 10 nm et plus généralement entre 1 et 30 nm, sans dégrader la couche sous-jacente, typiquement la couche active du transistor de type SOI.

L'étape de modification réalisée à partir d'un plasma modifie la couche poreuse de manière continue depuis la surface de la couche poreuse et sur une épaisseur comprise entre 1 nm et 30nm et de préférence entre 1nm et 10 nm et de préférence égale à 5 ou 6nm.

Selon un mode de réalisation particulièrement avantageux, l'implantation et le retrait de la couche poreuse sont réalisées dans un même réacteur plasma. Une modification de la couche à retirer réalisée par une implantation par plasma permet ainsi d'effectuer la modification de la couche et la gravure dans une même chambre ce qui est très

Le procédé de l'invention est défini par la revendication indépendante 1.

D'autres caractéristiques optionnelles de l'invention, qui peuvent être mises en oeuvre de façon combinée selon toutes combinaisons ou de manière alternative, sont indiquées ci-après :
- Avantageusement, l'épaisseur de la couche active est de préférence inférieure à 20nm. Elle est comprise de préférence entre 3 et 30 nm.
- Avantageusement, la couche poreuse présente une constante diélectrique inférieure à celle des espaceurs de protection.
- De manière préférentielle mais non limitative, l'étape de gravure et la modification sont effectuées au cours d'une seule étape au cours de laquelle les ions utilisés pour graver la couche de protection modifient la couche poreuse afin de former la couche modifiée.
- La gravure réalisée à l'étape de gravure est effectuée à l'aide d'un plasma à base d'argon (Ar) d'oxygène (O2) ou d'azote (N2). De préférence, le plasma ne comporte que de l'argon (Ar), de l'oxygène (O2) ou de l'azote (N2).
- La modification de la couche poreuse est effectuée par pénétration d'ions d'un plasma. Ce plasma est configuré, en particulier son énergie et la nature des ions, de manière à ce que les ions aient une énergie suffisante pour provoquer une déplétion des liaisons au sein du matériau diélectrique poreux. Selon un mode de réalisation particulier, la modification est effectuée à l'aide d'un plasma à base d'argon (Ar), d'O2 ou de N2.
- Selon un exemple préféré, l'étape de formation de la couche de protection est réalisée pour former une couche de protection dont l'épaisseur est comprise entre 2 nanomètre (nm) et 3 nm.
- De préférence, la couche de protection présente une constante diélectrique inférieure ou égale à 7.
- Le matériau de la couche de protection est compatible avec un nettoyage par voie sèche ou humide réalisé à l'étape de retrait de la couche modifiée. Le matériau de la couche de protection est choisi de manière à résister à la gravure sélective (par voie sèche ou humide) réalisée à l'étape de retrait de la couche modifiée. Avantageusement, la couche de protection est une couche de nitrure uniquement ou une couche de nitrure de silicium (par exemple Si3N4 ou SiN). Dans un autre mode de réalisation, la couche de protection est une couche de nitrure de bore (BN). Elle peut également être une couche de SiO2, de SiOCH non poreux ou de silicium-carbone-bore-azote (SiCBN).
- Avantageusement, l'étape de formation de la couche poreuse est réalisée pour former une couche poreuse dont l'épaisseur est de préférence inférieure à 10 nm typiquement 5 ou 6 nm.
- Avantageusement la modification de la couche poreuse effectuée à l'aide d'un plasma est réalisée de manière à implanter la couche poreuse de manière continue depuis la surface de la couche poreuse par laquelle les ions du plasma pénètrent. Cela permet de modifier la couche poreuse sur toute son épaisseur et depuis sa face libre. Il n'y a ainsi pas de zone superficielle de la couche poreuse qui n'est pas implantée. La vitesse de gravure de la couche poreuse peut être plus uniforme. La gravure de la couche poreuse est alors mieux maîtrisée et les risques de surgraver la couche poreuse sont écartés. Cet avantage est d'autant plus intéressant que la couche active est fine, comme cela est le cas dans les transistors pour lesquels l'épaisseur de la couche active est inférieure à 30 ou 20nm. En effet, si la couche active est fine une gravure involontaire d'une portion d'épaisseur de la couche active dégrade lourdement les performances du transistor. Par ailleurs, en maîtrisant mieux la gravure de la couche poreuse placée directement au contact de la couche active en dehors de la grille, on évite qu'une portion de la couche poreuse demeure sur la couche active ce qui aurait également pour conséquence de dégrader les performances du transistor.
- L'étape de modification réalisée à partir d'un plasma modifie la couche poreuse de manière continue depuis la surface de la couche poreuse et sur une épaisseur comprise entre 1 nm et 30nm et de préférence entre 1nm et 10 nm.
- L'étape de formation de la couche poreuse est par exemple effectuée par un procédé de dépôt chimique en phase vapeur assisté par plasma (PECVD), de sorte à former une couche poreuse dont l'épaisseur est comprise entre 5 nm et 6 nm.
- Typiquement, la couche poreuse présente une constante diélectrique inférieure à 7 et de préférence inférieure à 4 et de préférence inférieure à 3.1 et de préférence inférieure ou égale à 2. ; une telle couche de protection peut être qualifiée de couche low-k, c'est-à-dire à faible constante de diélectrique.
- Préférentiellement, la couche poreuse est une couche de SiOCH poreux.
- La couche modifiée est formée d'oxyde de silicium (SiO2).
- L'étape de retrait de la couche modifiée est effectuée par gravure humide sélective audit matériau semi-conducteur de la couche active.
- Le matériau semi-conducteur est du silicium et l'étape de retrait de la couche modifiée est effectuée par gravure humide sélectivement au silicium (Si). De manière préférentielle mais non limitative, la gravure sélective au silicium à l'étape de retrait de la couche modifiée est obtenue à l'aide d'une solution à base d'acide fluorhydrique (HF).
- Alternativement, cette étape de retrait est effectuée par gravure sèche sélective audit matériau semi-conducteur de la couche active.
- Le matériau semi-conducteur est du silicium et l'étape de retrait de la couche modifiée est effectuée par gravure sèche sélective au silicium (Si). De manière préférentielle mais non limitative, la gravure sèche est effectuée dans un plasma à base de trifluorure d'azote (NF3) et d'ammoniac (NH3).
- Avantageusement, la gravure sèche comprend : une étape de gravure consistant en la formation de sels solides ; une étape de sublimation des espèces solides. Ce mode de réalisation permet d'obtenir une très bonne sélectivité de la gravure de la couche poreuse modifiée par rapport à la couche poreuse non modifié et au matériau semi-conducteur non modifié. En particulier, cette sélectivité de la gravure est très supérieure (typiquement un facteur 10 au moins) à celle obtenue avec une solution de HF.
- Ladite modification est effectuée de sorte à modifier la couche poreuse dans toute son épaisseur sur toutes les surfaces parallèles au plan d'un substrat sur lequel repose la grille et à ne pas modifier la couche poreuse dans toute son épaisseur sur les surfaces perpendiculaires à ce plan.
- Le matériau semi-conducteur est pris parmi: le silicium (Si), le germanium (Ge), le silicium-germanium (SiGe).
- L'étape de retrait de la couche modifiée est effectuée de manière à conserver la couche poreuse sur les flancs de la grille.
- Après l'étape de retrait de la couche modifiée les portions de couche poreuse recouvrant les flancs de la grille sont entièrement recouvertes par les espaceurs de protection formés par la couche de protection.
- Le transistor est un transistor de type FDSOI.
- Le transistor est un transistor de type FinFET.
- Selon un mode de réalisation, après l'étape de retrait de la couche modifiée, on effectue une étape de retrait des espaceurs de protection recouvrant les flancs de la grille. Cette étape est obtenue par gravure à l'aide d'une solution à base d'acide phosphorique (H3PO4).Cette solution permet de définir la constante diélectrique à partir du matériau poreux uniquement. Ce mode de réalisation permet de graver le nitrure sans consommer le matériau poreux ou la couche active.
- De préférence, la couche de protection est au contact de la couche active. De préférence, la couche de protection est au contact de la couche poreuse. De préférence, la couche poreuse est au contact des flancs de la grille formé d'un matériau semi-conducteur.

Un autre aspect de la présente demande de brevet concerne un dispositif microélectronique comportant au moins un empilement comportant une grille surmontant une couche active en matériau semi-conducteur, la couche active surmontant une couche isolante et un substrat de support, et des espaceurs disposés sur des flancs de la grille. Les espaceurs comprennent : des espaceurs poreux recouvrant les flancs de la grille et présentant une constante diélectrique égale ou inférieure à celle de l'oxyde de silicium (SiO2).

Selon un mode de réalisation optionnel, le transistor comporte des espaceurs de protection recouvrant les espaceurs poreux et présentant une constante diélectrique égale ou inférieure à 7.

De manière optionnelle le dispositif peut comporter au moins l'une quelconque des caractéristiques suivantes prises seules ou en combinaison :
- Avantageusement, l'épaisseur de la couche active est inférieure à 30nm et de préférence inférieure à 20nm.
- Avantageusement, l'épaisseur de la couche poreuse est inférieure à 10nm. Avantageusement, elle est égale à 5 ou 6nm.
- Avantageusement, de part et d'autre de la grille, la couche poreuse est disposée directement au contact de la couche active.
- Avantageusement, les espaceurs poreux sont en SiOCH poreux.
- Dans un autre mode de réalisation, les espaceurs poreux sont formés d'un matériau dont la constante diélectrique est égale ou inférieure à celle du SiOCH poreux.
- De préférence, les espaceurs de protection sont en nitrure tel que du nitrure et par exemple du nitrure de silicium tel que Si3N4 ou SiN.
- Dans un autre mode de réalisation, les espaceurs de protection sont en nitrure de bore (BN), en SiO2, en SiOCH non poreux ou en SiCBN.
- L'épaisseur des espaceurs de protection est comprise par exemple entre 0.5 nm et 2 nm et est de préférence égale à 1 nm.
- L'épaisseur des espaceurs poreux est comprise par exemple entre 5 nm et 6 nm.

### BRÈVE DESCRIPTION DES FIGURES

Les buts, objets, ainsi que les caractéristiques et avantages de l'invention ressortiront mieux de la description détaillée d'un mode de réalisation de cette dernière qui est illustré par les dessins d'accompagnement suivants dans lesquels :
Les FIGURE 1a à 1d montrent, d'une part, une vue en coupe d'un exemple de transistor MOSFET de type FDSOI en cours de réalisation et, d'autre part, illustrent différents défauts qui peuvent être observés sur des structures de transistors FDSOI lors de la gravure des espaceurs en utilisant l'un ou l'autre des procédés standard de gravure anisotrope développés par l'industrie de la microélectronique.
Les FIGURES 2a à 2i illustrent la structure tridimensionnelle (3D) d'un exemple de transistor MOSFET de type FinFET et les problèmes de gravure qui se posent dans ce cas.
La FIGURE 3 résume de principales étapes d'un exemple détaillé d'un procédé de formation des espaceurs d'un transistor selon l'invention appliqué à la réalisation de transistors de type FDSOI.
Les FIGURES 4a à 4e illustrent respectivement une structure d'un transistor obtenue à l'issue d'une des étapes du procédé selon un mode de réalisation de l'invention.
La FIGURE 5 montre les étapes du retrait par voie sèche de la couche modifiée qui a été modifiée par implantation, par exemple, d'hydrogène.
La FIGURE 6 montre un premier exemple de structure finale d'un transistor de type FDSOI selon un mode de réalisation de l'invention.
La FIGURE 7 illustre un deuxième exemple de structure finale d'un transistor selon un autre mode de réalisation de l'invention dans lequel le transistor comporte uniquement des espaceurs poreux.

Les dessins joints sont donnés à titre d'exemples et ne sont pas limitatifs de l'invention. Ces dessins sont des représentations schématiques et ne sont pas nécessairement à l'échelle de l'application pratique. En particulier, les épaisseurs relatives des couches et des substrats ne sont pas représentatives de la réalité.

### DESCRIPTION DÉTAILLÉE DE L'INVENTION

Il est précisé que dans le cadre de la présente invention, le terme « sur », « surmonte », « recouvrir » ou « sous jacent » ou leurs équivalent ne signifient pas obligatoirement « au contact de ». Ainsi par exemple, le dépôt d'une première couche sur une deuxième couche, ne signifie pas obligatoirement que les deux couches sont directement au contact l'une de l'autre mais cela signifie que la première couche recouvre au moins partiellement la deuxième couche en étant soit directement à son contact soit en étant séparée d'elle par une autre couche ou un autre élément.

Dans la description qui suit, les épaisseurs sont généralement mesurées selon des directions perpendiculaires au plan de la face inférieure de la couche à graver ou d'un substrat sur lequel la couche inférieure est disposée. Ainsi, les épaisseurs sont généralement prises selon une direction verticale sur les figures représentées. En revanche l'épaisseur d'une couche recouvrant un flanc d'un motif est prise selon une direction perpendiculaire à ce flanc.

Les constantes diélectriques sont par exemple mesurées par la méthode bien connue dite « Mercury Probe » qui signifie par goutte de mercure.

Comme on l'a vu un objet de l'invention est de s'affranchir de tous ou d'au moins certains des problèmes mentionnés ci-dessus.

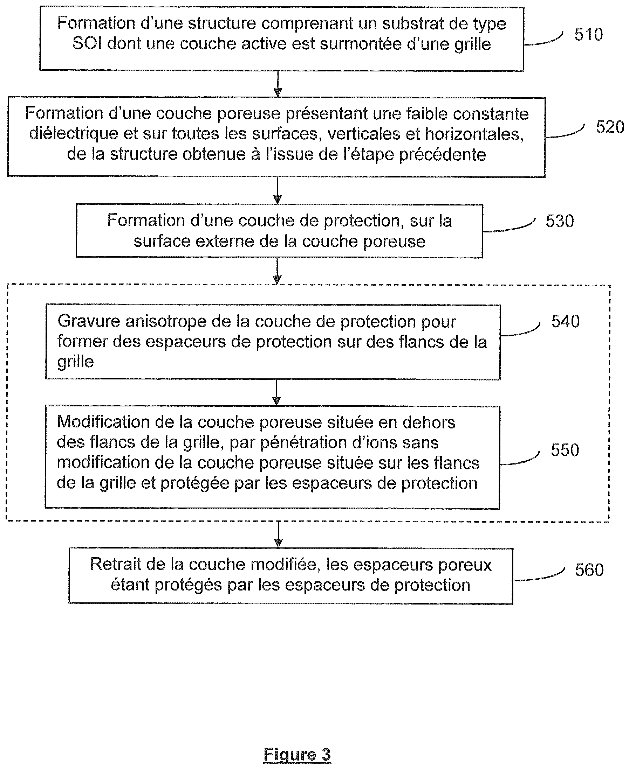

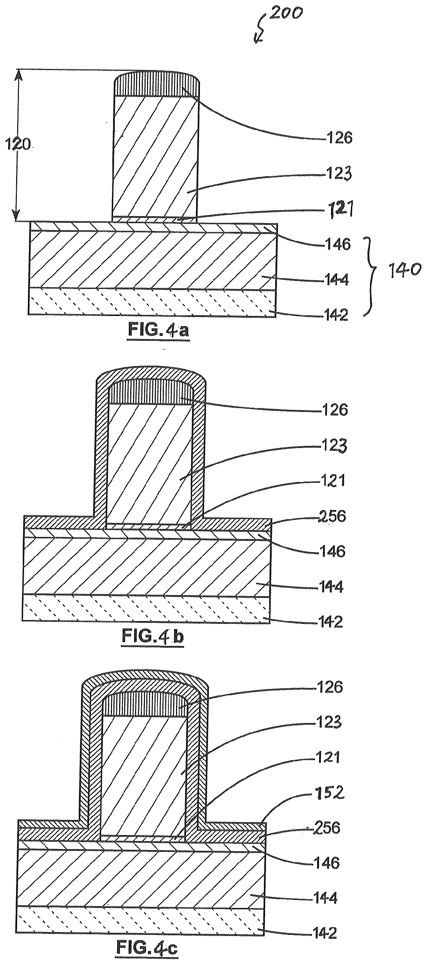

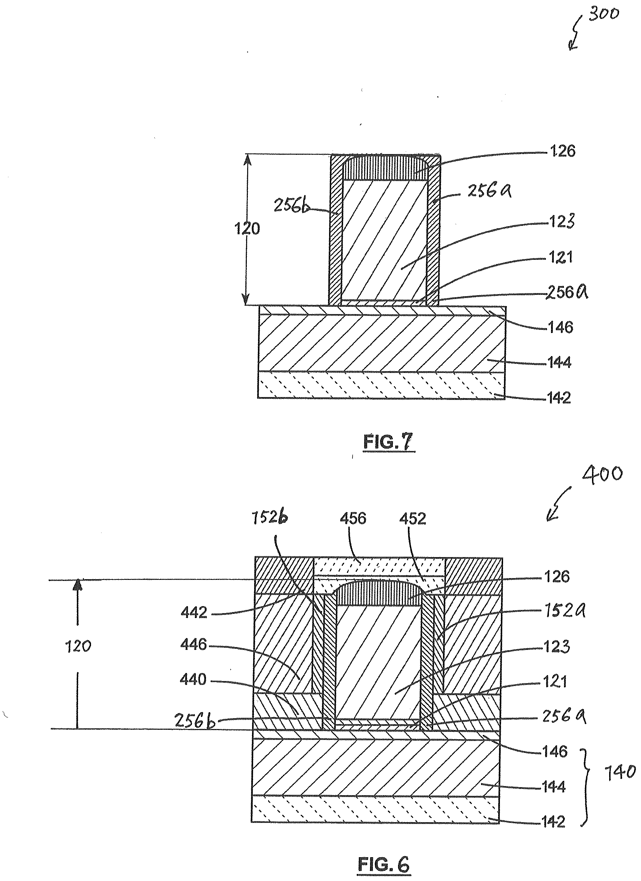

La **figure 3** résume les principales étapes 510 à 560 d'un exemple détaillé d'un procédé de formation des espaceurs d'un transistor selon l'invention, appliqué à la réalisation de transistors de type FDSOI. Ces étapes 510 à 560 peuvent également s'appliquer à la formation d'espaceurs sur les flancs d'une grille d'un transistor de type FinFET. Les étapes 510 à 560 seront respectivement détaillées dans les paragraphes suivants concernant les **figures 4a à 4e** **et** **7** illustrant respectivement une structure d'un transistor 200 obtenue à l'issue d'une des étapes 510 à 560 selon un mode de réalisation de l'invention.

La **figure 4a** illustre une structure d'un transistor 200 de type SOI dont la couche active 146 est surmontée d'une grille 120. Cette figure **4a** est obtenue à l'issue de l'étape 510 de la **figure 3****.**

Cette étape 510 consiste à réaliser un substrat élaboré 140 de type SOI, à partir d'un substrat 142, souvent désigné substrat massif (bulk substrat en anglais), une couche isolante initiale 144 et la couche active 146, cette dernière étant de préférence en matériau semi-conducteur et destinée à former ultérieurement un canal de conduction du transistor 200.

Alternativement, le matériau semi-conducteur est pris parmi: le germanium (Ge), le silicium germanium (SiGe).

En plus d'une couche de silicium polycristallin 123 on retrouve dans un empilement des couches formant la grille 120 tout d'abord une mince couche isolante d'oxyde de grille 121 à travers laquelle un champ électrique va pouvoir se développer pour créer un canal de conduction sous jacent entre source et drain quand une tension électrique suffisante est appliquée sur la grille 120. Dans les transistors MOSFET les plus récents il est mis en oeuvre une technologie qualifiée du vocable anglais de « high-k/metal gâte » c'est-à-dire que la couche diélectrique 121 est faite d'un matériau isolant à haute permittivité (high-k) couverte par une couche métallique (metal gate; non-illustrée en figures) de la grille 120. Cette technologie a été développée notamment pour réduire les courants de fuite à travers la grille 120 qui devenaient beaucoup trop importants en raison de la diminution de l'épaisseur de la couche diélectrique 121 jusqu'à des dimensions atomiques. À ce stade, l'empilement de couches de la grille 120 comprend aussi un masque dur 126 de protection qui sera enlevé ultérieurement pour permettre la reprise de contact sur cette électrode. Ce masque dur 126, qui reste en place après gravure de la grille, est typiquement fait d'oxyde de silicium (SiO2).Son rôle est de protéger le sommet de la grille 120 de tout dommage lors de la réalisation des étapes suivantes et notamment celles de gravure des espaceurs.

De préférence, la couche diélectrique 121 est disposée au contact de la couche active 146 formant le canal de conduction. De préférence, la couche métallique est disposée au contact de la couche diélectrique 121. De préférence, la couche de silicium polycristallin 123 est disposée directement au contact de l'oxyde de grille formée par la couche diélectrique 121 si la couche métallique est absente ou est disposée directement au contact de la couche métallique.

La **figure 4b** illustre la structure obtenue à l'issue de l'étape 520 de formation d'une couche poreuse 256 présentant une faible constante diélectrique.

La couche poreuse 256 obtenue à l'issue de l'étape 520 présentant une faible constante diélectrique k égale ou inférieure à une valeur 4, de préférence entre 2.1 et 3. La couche poreuse 256 obtenue est de préférence en SiOCH poreux.

De manière encore plus avantageuse mais non limitative, la constante diélectrique k est égale ou inférieure à celle du SiOCH poreux.

De plus, le matériau de la couche poreuse 256 est suffisamment sensible aux ions du plasma utilisés ultérieurement de sorte que cette couche poreuse 256 puisse être transformée pour former une couche modifiée 166 (décrite ultérieurement). En outre, cette couche poreuse 256 est apte à être enlevée sélectivement au matériau semi-conducteur tel que le silicium de la couche active 146 et au matériau de la couche de protection 152 formée à l'étape 530 (décrite ultérieurement).

Cette étape 520 se fait de préférence à l'aide d'une méthode de dépôt dite PECVD, acronyme de l'anglais « Plasma-Enhanced Chemical Vapor Déposition », c'est-à-dire « dépôt chimique en phase vapeur assisté par plasma ». Ce type de dépôt qui se pratique à pression atmosphérique permet en effet un dépôt uniforme sur toutes les surfaces quelle que soit leur orientation. On obtient ainsi un dépôt que l'on peut qualifier de conforme.

Ainsi, de préférence, la couche poreuse 256 obtenue est d'épaisseur préférentiellement sensiblement uniforme, sur toutes les surfaces, verticales et horizontales, des dispositifs en cours de fabrication.

De manière préférentielle mais non limitative, la couche poreuse 256 est disposée directement au contact de la couche en silicium polycristallin 123 au niveau des flancs de la grille 120 et également au contact de la couche active 146.

De préférence, l'épaisseur de la couche poreuse 256 est comprise entre 5 nanomètres (nm) et 6 nm afin d'avoir une épaisseur totale d'espacement, définie par l'ensemble de la couche poreuse 256 et d'une couche de protection 152 décrite ultérieurement, formée de 9 nm.

La porosité de la couche poreuse 256 est comprise de préférence entre 5% et 70% et de préférence entre 10% et 50% et de préférence entre 15% et 40%. La porosité plus élevée de la couche poreuse 256 signifie que la couche poreuse 256 est plus sensible à un plasma ultérieurement appliqué lors d'une étape suivante 550. Plus la couche 256 est poreuse, plus elle sera aisément modifiée comme indiqué par la suite.

La figure **4c** illustre une étape 530 de formation d'une couche de protection 152, d'épaisseur préférentiellement sensiblement uniforme, sur la surface supérieure de la couche poreuse 256, c'est-à-dire sur toutes les surfaces, verticales et horizontales, des dispositifs en cours de fabrication. Cette étape 530, qui n'est pas différente de l'étape correspondante des procédés connus et qui a déjà été mentionnée en figure 1a, se fait de préférence à l'aide d'une méthode de dépôt dite LPCVD, acronyme de l'anglais « low pressure chemical vapor déposition », c'est-à-dire « dépôt chimique en phase vapeur à faible pression ». Ce type de dépôt qui se pratique à pression atmosphérique permet en effet un dépôt uniforme sur toutes les surfaces quelle que soit leur orientation.

La couche de protection 152 obtenue à l'issue de l'étape 530 est de préférence une couche de nitrure, tel qu'une couche de nitrure de silicium d'un composé chimique Si3N4 ou SiN. Dans un autre mode de réalisation, la couche de protection 152 est une couche de nitrure de bore (BN), de SiO2, de SiCBN ou de SiOCH non poreux ou une couche présentant une constante diélectrique égale ou inférieure à celle du nitrure de silicium.

De plus, le matériau de la couche de protection 152 doit être compatible avec un nettoyage par voie sèche ou humide réalisé à une étape suivante 560 pour enlever une couche modifiée 166 (décrite ultérieurement).

De manière préférentielle mais non limitative, la couche de protection 152 est disposée directement au contact de la couche poreuse 256.

L'épaisseur de la couche de protection 152 est de préférence suffisamment importante, pour que après la réalisation de l'étape de gravure 540, il reste des portions résiduelles 152a, 152b de la couche de protection 152 au niveau des flancs de la grille 120. Ces portions résiduelles 152a, 152b seront utilisées pour protéger des portions 256a, 256b de la couche poreuse 256 au niveau des flancs de la grille 120 lors de la réalisation d'une étape suivante 550 (décrite ultérieurement). Ces portions résiduelles 152a, 152b forment ainsi des espaceurs de protection ou des couches de protection pour la couche poreuse 256. Les espaceurs de protection s'étendent sur toute toute la hauteur des flancs de la grille 120.

Dans un mode de réalisation préféré, l'épaisseur de la couche de protection 152 est comprise entre 2 nm et 3 nm. La consommation de l'épaisseur de la couche de protection 152 au cours de l'étape suivante de gravure 540 est environs entre 1 nm et 2.5 nm. Lesdites portions résiduelles 152a, 152b présenteront donc, après l'étape de gravure 540, une épaisseur comprise entre 0.5 nm et 2 nm, de préférence de 1 nm.

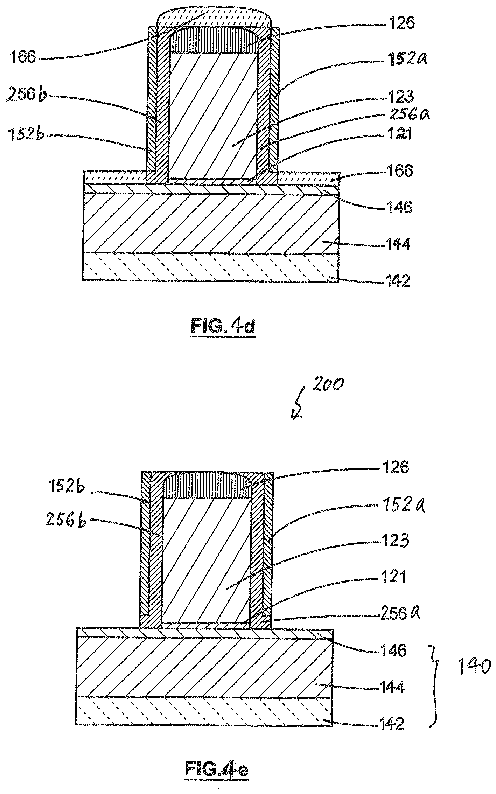

La **figure 4d** illustre la structure du transistor 200 à l'issue de l'étape de gravure 540 de la couche de protection 152 et de la modification 550 de la couche poreuse 256.

L'étape de gravure 540 est réalisée de manière anisotrope et de sorte à conserver les portions résiduelles 152a, 152b de la couche de protection 152 uniquement au niveau des flancs de la grille 120. Ces portions résiduelles 152a, 152b constitueront des espaceurs de protection 152a, 152b de la grille 120, par exemple des espaceurs de nitrure. De préférence, ces espaceurs recouvrent l'intégralité des flancs de la grille 120.

De manière préférentielle mais non limitative, la gravure 540 est réalisée dans un réacteur plasma de type inductif ou capacitif, et pour former un plasma d'Argon (Ar).

Un exemple de mise en oeuvre de l'étape 540 sera fourni dans un paragraphe ci-dessous concernant la modification 550 de la couche poreuse 256.

Lesdites portions résiduelles 152a, 152b, c'est-à-dire les espaceurs de protection 152a, 152b de la grille 120, présentent une épaisseur comprise entre 0.5 nm et 2 nm, de préférence de 1 nm.

Ensuite, la modification 550 de la couche poreuse 256 telle que formée à l'issue de l'étape 520, se fait par pénétration d'espèces au sein de la couche poreuse 256 afin de former une couche modifiée 166. Cette modification 550 est réalisée de manière anisotrope et de sorte à modifier la couche poreuse 256 sur toute son épaisseur au-dessus de la grille 120 et au-dessus de la couche active 146 en laissant en place des portions non-modifiées 256a, 256b de la couche poreuse 256 au niveau des flancs de la grille 120. Ainsi, au niveau des flancs de la grille 120, la couche poreuse 256 est non modifiée.

Plus précisément, lors de cette modification 550, une légère déflection des ions du plasma se fait sur les flancs de la structure obtenue à l'issue de l'étape précédente 540. L'épaisseur des espaceurs de protection 152a, 152b est choisie de manière à être suffisamment épaisse pour que les de cette déflection n'atteignent pas les espaceurs poreux 256a, 256b. Typiquement, la déflection des ions se produit dans la couche de protection sur une épaisseur comprise entre 1 à 2 nm. Dans ce cas, l'épaisseur de la couche de protection 152 formées à l'étape précédente 530 ne doit pas être inférieure à 2 nm et sera de préférence comprise entre 2 et 3 nm.

Ainsi, l'épaisseur de la couche poreuse 256 située au niveau des flancs de la grille 120 ne reçoit donc pas d'ions ou n'en reçoit pas suffisamment pour être modifiée. Au contraire, les portions de couche poreuse 256 qui ne sont pas situées sur les flancs de la grille reçoivent des ions du plasma et s'en trouvent modifiée.

Comme indiqué précédemment, la modification de la couche poreuse est effectuée par une implantation à l'aide d'un plasma. Cela a pour avantage de permettre une implantation en continue depuis la surface libre de la couche poreuse et sur une épaisseur faible, typiquement comprise entre 0 et 30nm voire entre de l'ordre de 5 ou 6nm. Elle permet également de bénéficier d'une sélectivité améliorée dès le début de la gravure et d'une vitesse de gravure constante, conduisant à une précision de gravure améliorée. Elle permet également d'effectuer la modification et le retrait de la couche poreuse modifiée dans une même enceinte.
L'emploi d'un plasma pour implanter la couche poreuse permet ainsi de retirer une couche poreuse très fine sans risquer de graver la couche active 146 sous-jacente.

Le plasma peut comprendre des type d'ions variés (tel que des ions Argon, O2 ou N2 pris séparément ou sous forme de mélange), temps que la nature de ces ions et les paramètres du plasma, en particulier sont énergie, permettent d'assurer une déplétion des groupements méthyles du matériau poreux. Ainsi, cette pénétration des ions du plasma casse les liaisons du matériau poreux de la couche poreuse 256.

Dans le présent mode de réalisation, cette modification 550 est de préférence effectuée par utilisation d'un plasma de type Argon.

De manière préférentielle mais non limitative, les espèces d'un plasma employé pour effectuer ladite modification 550 de la couche poreuse 256 sont les espèces déjà utilisés comme la base de la gravure plasma effectuée à l'étape précédente de gravure 540 de la couche de protection 152.

Par exemple, dans le présent mode de réalisation, les ions Argon présents dans le plasma permettent dans un premier temps (à l'étape de gravure 540) de graver, de manière anisotrope, la couche de protection 152 du Si3N4 ou SiN en conservant les portions résiduelles 152a, 152b de la couche de protection 152 au niveau des flancs de la grille 120, puis de modifier, également de manière anisotrope, la couche poreuse 256 de SiOCH poreux en la transformant en SiO2 poreux lorsque la couche poreuse 256 est au contact dudit plasma d'Argon ou d'un plasma d'O2. Le bombardement ionique brise des groupements méthyles dans la couche poreuse 256 de SiOCH lors de la transformation de cette dernière en SiO2 tandis que le substrat SOI 140 n'est pas impacté par ledit bombardement ionique. Ainsi, la couche modifiée 166 obtenue à l'issue de la modification 550 est une couche par exemple l'oxyde de silicium (SiO2) poreux.

Les espaceurs de protection 152a, 152b de la grille 120 protègent, comme mentionné ci-dessus, les portions non-modifiées 256a, 256b de la couche poreuse 256 lors de cette modification 550. Les portions non-modifiées 256a, 256b constituent alors des espaceurs poreux 256a, 256b se situant entre la grille 120 et les espaceurs de protection 152a, 152b.

Un exemple de mise en oeuvre de l'étape 540 dans un réacteur de gravure plasma d'Argon pour graver 3nm de la couche de protection 152 suivi d'une modification 550 de toute l'épaisseur de 6nm de la couche poreuse 256 de SiOCH poreux, est réalisé en fonction du temps en secondes et de la puissance de la polarisation (bias) en watts, comme décrit ci-dessous:

| | |
|---|---|
| Réacteur de gravure : | plasma d'Argon de 250 sccm |
| Épaisseur de la couche de protection 152 à graver : | 3 nm |
| Épaisseur de la couche poreuse 256 de SiOCH poreux à modifier : | 6 nm |
| Puissance de la source : | 500 Watts |
| Puissance de polarisation (énergie des ions) : | 200 Watts |
| Pression: | 10 milli Torr |
| Température : | 50 °C |
| Temps : | 60 secondes |

Avantageusement, les paramètres d'implantation, en particulier l'énergie communiquée aux ions, la durée et la dose d'implantation sont prévus de sorte que la couche modifiée 166 puisse être ultérieurement (l'étape 560) gravée sélectivement par rapport à la couche active 146.

Avantageusement, ces paramètres sont également réglés de manière à ce que la couche modifiée 166 puisse être gravée sélectivement par rapport aux espaceurs de protection (lesdites portions résiduelles) 152a, 152b.

Avantageusement, ces paramètres sont également réglés de manière à ce que la couche modifiée 166 puisse être gravée sélectivement par rapport à une couche faite d'un oxyde typiquement un oxyde dudit matériau semi-conducteur, cette dernière formant par exemple une couche d'oxyde de grille. Typiquement, la gravure est sélective du matériau tel que l'oxyde de silicium SiO2 poreux de la couche modifiée 166 formée à l'aide du plasma d'Argon vis-à-vis de la couche active 146 et des espaceurs de protection (portions résiduelles) 152a, 152b.

Suivant le mode de réalisation décrit ci-dessus, on pourra donc préférer utiliser un graveur plasma pour réaliser l'étape de gravure 540 et la modification 550 en une seule étape, notamment pour les raisons suivantes :
- le coût de l'appareillage est moins élevé ;
- les temps de cycle de fabrication peuvent être plus courts puisque l'étape de gravure 540 de la couche de protection 152 et la modification 550 de la couche poreuse 256 peuvent alors se faire dans le même appareillage sans remise à l'air des dispositifs en cours de fabrication.

La gravure 540 résulte d'une réaction physico-chimique classique et comprend de préférence une gravure au CH3F avec du O2 et du He.

En revanche, dans un autre mode de réalisation, la modification 550 peut être réalisée indépendamment de l'étape de gravure 540 par exemple par plasma utilisant des espèces ioniques distinctes de celles utilisées pour l'étape de gravure 540, ce qui peut être avantageux.

L'implantation s'effectue par exemple dans un plasma de type O2. On notera ici que cette étape de modification 550 de la couche poreuse 256 à graver peut se pratiquer de nombreuses façons différentes en adaptant toutes sortes de moyens couramment employés par l'industrie de la microélectronique. On utilise notamment des graveurs standard dont lesquels on peut développer des plasmas à faible ou haute densité et où on peut contrôler l'énergie des ions pour permettre l'implantation d'espèces telles que Ar, N2, O2, He, H ci-dessus destinées à modifier la couche poreuse 256 à graver. On peut aussi utiliser un type de plasma dit par immersion couramment utilisé pour pratiquer une implantation d'espèces en surface d'un dispositif en cours de fabrication.

L'étape de modification 550 est avantageusement très anisotrope pour la formation des espaceurs poreux 256a, 256b sur les flancs de la grille 120 en raison de la directionnalité des ions du plasma. Elle affecte donc préférentiellement les surfaces horizontales, c'est-à-dire toutes les surfaces parallèles au plan du substrat élaboré 140. La couche modifiée 166 obtenue comprend donc l'épaisseur modifiée de la couche poreuse 256 au-dessus de la surface supérieure de la couche active 146 et celle au-dessus de la surface supérieure du masque dur 126 de la grille 120. L'épaisseur de la couche poreuse 256 sur les surfaces verticales par rapport au plan du substrat élaboré 140, c'est-à-dire sur les surfaces latérales de la grille 120, est protégée par les espaceurs de protection 152a, 152b et donc conservée pour former les espaceurs poreux 256a, 256b.

Typiquement, comme mentionné dans l'exemple ci-dessus, une épaisseur de 6 nm de la couche poreuse 256 sur les surfaces horizontales peut être modifiée au cours de cette opération. De plus, une épaisseur totale d'espacement de la grille 120 est comprise entre 7 nm et 8 nm, cette épaisseur totale étant définie par l'ensemble formé des espaceurs de protection 152a, 152b et des espaceurs poreux 256a, 256b.

Les épaisseurs modifiées de la couche poreuse 256 dépendent des conditions de mise en oeuvre, notamment des moyens employés (plasma).

La **figure 4e** illustre le résultat final de l'étape de retrait 560 après que l'on ait procédé à la gravure, c'est-à-dire au retrait de la couche modifiée 166.

Pour le retrait de la couche modifiée 166 de l'oxyde de silicium (SiO2) poreux, une gravure humide à base d'acide fluorhydrique (HF) qui combine le retrait de la couche modifiée 166 avec un nettoyage humide de la tranche contenant les dispositifs en cours de fabrication, est avantageusement mais non limitative utilisée, car après cette gravure humide, conventionnellement un nettoyage humide (traduction de l'anglais « wet clean ») est réalisé pour nettoyer un wafer sur lequel est le transistor 200. Cette voie humide sera donc privilégiée pour enlever la couche modifiée 166 sélectivement au silicium de la couche active 146 tout en nettoyant le wafer. Cela simplifie le procédé et apporte un gain de temps.

À titre d'exemple, pour enlever une épaisseur comprise entre 5 nm et 6 nm de l'oxyde de silicium poreux de la couche modifiée 166, il faut de l'ordre de 15 secondes avec une solution d'acide fluorhydrique (HF) à 1%. Cette durée dépend évidemment directement de l'épaisseur de la couche poreuse 256 qui a été modifiée.

Cette étape 560 peut être effectuée de manière répétée. De préférence, si l'épaisseur de la couche poreuse 256 formée à l'étape 520 est comprise entre 5 et 6 nm, comme indiqué dans l'exemple ci-dessus, cette étape de retrait 560 est réalisée en une seule fois grâce à la très grande réactivité du SiOCH poreux modifié (en SiO2 poreux) de la couche modifiée 166. En revanche, si la couche poreuse 256 présente une épaisseur supérieure à 6 nm, on peut alors envisager d'effectuer plusieurs séquences des étapes 560. Le nombre de séquences est calculé en fonction de la vitesse de gravure de la première séquence.

L'arrêt de cette gravure se fait sur les espaceurs de protection 152a, 152b ou/et sur le silicium monocristallin de la couche active 146 ou/et encore sur le masque dur 126 au sommet de la grille 120 jusqu'à la disparition de la couche modifiée 166 sur toutes les surfaces horizontales. Le SiO2 poreux qui forme la couche modifiée 166 se grave très rapidement par rapport au SiO2 (dense) du masque dur 126.

Pour éviter les problèmes des procédés conventionnels de gravure des espaceurs décrits dans les figures 1b à 1d, il est nécessaire que la gravure de la couche modifiée 166 soit la plus sélective possible par rapport au silicium notamment afin de ne pas attaquer le silicium de la couche active 146. Par exemple, dans ce mode de réalisation de gravure humide, il n'y a aucune consommation de silicium de la couche active 146 due à l'utilisation de la solution gravure à base d'acide fluorhydrique (HF).

À l'issue de cette opération, il ne reste donc que des motifs verticaux, essentiellement sur les flancs de la grille 120; c'est-à-dire les portions non-modifiées 526a, 526b de la couche poreuse 526 constituant alors les espaceurs poreux 526a, 526b de la grille 120 du transistor 200 de de type FDSOI. De plus, la gravure de la couche modifiée 166 peut être également réalisée pour la réalisation des espaceurs d'un transistor tridimensionnel de type FinFET.

Une gravure sèche de la couche poreuse modifiée 166 sélective au silicium de la couche active 146, au matériau des espaceurs de protection 152a, 152b et à l'oxyde de silicium (SiO2) du masque dur 126 de la grille 120 pourra alors être aussi pratiquée pour cette étape de retrait par voie sèche de la couche modifiée 166. On notera ici que ce type de gravure sèche est aussi qualifié de « nettoyage sèche » traduction de l'anglais « dry clean ».

La méthode est celle décrite par H. Nishini et ses coauteurs dans une publication en anglais intitulée « Damage-free selective etching of Si native oxides using NH3/NF3 and SF6/H2O down flow etching » parue dans le « Journal of Applied Physics » volume 74 (2), en juillet 1993.

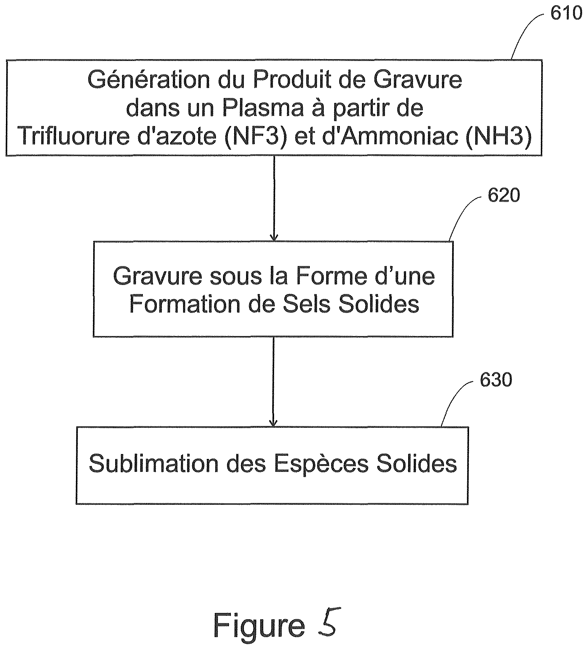

Le principe du retrait par voie sèche de la couche modifiée 166 comprend les étapes suivantes 610 à 630 illustrées en **figure 5** qui s'effectuent dans une chambre de réaction où l'on forme un plasma. Les épaisseurs traitées sont typiquement comprises entre 1 nm et quelques dizaines de nanomètres typiquement inférieure à 30nm.

Une première étape 610 consiste à générer le produit de gravure dans le plasma selon la réaction chimique suivante :

NF₃+NH₃ → NH₄F + NH₄F.HF

qui fait réagir du trifluorure d'azote (NF₃) avec de l'ammoniac (NH₃).

La gravure se fait au cours d'une deuxième étape 620, à une température de l'ordre de 30°C et plus généralement entre 10°C et 50°C, sous la forme d'une formation de sels selon la réaction chimique suivante :

NH₄F or NH₄F.HF + SiNH → (NH₄)2SiF₆ (solide) + H₂

au cours d'une opération qui dure entre quelques secondes et quelques minutes et qui s'effectue sous une pression comprise entre quelques milli Torr et quelques Torr.

Les espèces solides qui sont formées au cours de cette opération sont ensuite sublimées 630 à une température supérieure à 100°C pendant quelques dizaines de secondes selon la réaction suivante :

(NH₄)2SiF₆ (solid) → SiF₄(g) + NH₃(g) + HF(g)

Par exemple, pour enlever une couche de 6 nm de SiOCH poreux de la couche poreuse 256, les flux de trifluorure d'azote (NF₃) et d'ammoniac (NH₃) sont respectivement de 5 sccm et de 300 sccm à 30°C pendant 20 secondes pour l'étape 620 de formation des sels qui est suivie par l'étape de sublimation 630 qui s'effectue à 180°C pendant 60 secondes.

Ce mode de réalisation permet d'obtenir une très bonne sélectivité de la gravure de la couche poreuse modifiée par rapport à la couche poreuse non modifié, au matériau semi-conducteur non modifié et à la couche de protection. En particulier, cette sélectivité de la gravure est très supérieure (typiquement un facteur 10 au moins) à celle obtenue avec une solution de HF.

La **figure 6** illustre une structure finale d'un transistor 400 de type FDSOI.

Le transistor 400 comprend un substrat élaboré 140 dont une couche active 146 est surmontée d'une grille 120 formés par réalisation de l'étape 510 par exemple. Le transistor 400 comprend en outre sur les flancs de la grille 120, des espaceurs de protection 152a, 152b et des espaceurs poreux 256a, 256b situés sur les flancs de la grille 120 et de préférence formés par réalisation des étapes 520 à 560 mentionnées ci-dessus, les espaceurs poreux 256a, 256b étant situés entre la grille 120 et les espaceurs de protection 152a, 152b. Le transistor 400 comprend également des source et drain (S/D) 440 disposés au contact de la couche active 146 et des espaceurs de protection 152a, 152b. Il comprend également une couche de pré-contact 446 disposée au-dessus des S/D 440 et au contact des espaceurs de protection 152a, 152b. Cette couche de pré-contact 446 s'étend depuis les S/D 440 et sur une hauteur correspondant au sommet de la grille 120, de manière à affleurer cette dernière mais sans recouvrir cette dernière.

Il comprend encore une couche de contact 442 surmontant la couche de pré-contact 446 et disposé au droit de cette dernière. Cette couche de contact 442 est destinée à former une zone de connexion du transistor 400. Le transistor 400 comprend également une couche d'arrêt de gravure des contacts (CESL, acronyme de l'anglais « contact edge stop layer ») 452 recouvrant le sommet de la grille 120 et disposée de préférence au contact du masque dur 126. Il comprend en outre une couche diélectrique pré-métallique (PMD, acronyme de l'anglais « pre-metal dielectric ») 456, comme illustré en **figure 6****.**

Pour former ce transistor, à l'issue de l'étape de retrait 560 de la couche modifiée 166, c'est-à-dire lorsqu'on a fini d'enlever la couche modifiée 166 sur toutes les surfaces horizontales, on procède à une opération de nettoyage dite « nettoyage humide » le plus souvent qualifiée par son vocable anglais de « wet clean », comme on l'a déjà noté précédemment.

On peut ensuite procéder à la formation des électrodes de source et de drain 440 et du transistor 400. Selon un mode de réalisation préférentiel mais non limitatif, un dopage qui va délimiter les source et drain 440 et donc la longueur d'un canal du transistor 400 peut se faire par implantation ionique. Les source et drain 440 sont de préférence de type surélevée et formés de préférence par croissance épitaxiale.

Les autres éléments 446, 442, 452, 456 du transistor 400 comme décrits ci-dessus sont réalisés de manière conventionnelle. Les informations des éléments du transistor 400 telles que leurs dimensionnements et la valeur de la constante diélectrique sont fournies dans le tableau ci-dessous.

| **Paramètres** | **Caractéristiques** | **Paramètres** | **Caractéristiques** |
|---|---|---|---|
| diélectrique de grille | Epaisseur = 2.3 nm, k (constante diélectrique) = 20 | S/D surélevés | Epaisseur = 15 nm, α = 70° |
| métal de grille | Epaisseur = 5 nm | Pitch | 64 nm |
| Grille Polysilicium | Epaisseur = 40 nm, L_{G} = 14 nm | Contact | Epaisseur = 26 nm |
| Gate cap. | Largeur = 6 nm | CESL | Epaisseur = 4 nm, k = 7 |
| Espaceurs de protection et espaceurs poreux | Epaisseur = 2.3 nm, k = 7 | PMD | Epaisseur = 36 nm, k = 3.9 |

Il faut noter que les éléments 446, 442, 452, 456 du transistor 400 sont illustrés en figure 6 pour montrer un exemple d'une structure finale du transistor 400. La présente invention n'est donc pas limitée à des méthodes de réalisation ni à des matériaux des éléments 446, 442, 452, 456 du transistor 400.

La **figure 7** illustre un autre transistor 300, ce transistor 300 comportant uniquement des espaceurs poreux 526a, 526b.

Selon le présent mode de réalisation, le procédé comprend, en plus des étapes 510-560 décrites précédemment, une étape additionnelle de retrait effectuée pour retirer les espaceurs de protection 152a, 152b déjà formés au niveau des flancs de la grille 120. Cette étape additionnelle de retrait peut être effectuée par exemple par voie humide en utilisant une solution de gravure à base d'acide phosphorique (H3PO4). Cette solution présente l'avantage de graver le nitrure des espaceurs de protection 152a, 152b sans consommer le SiOCH poreux des espaceurs poreux 256a, 256b ou le silicium de la couche active 146 du substrat élaboré 140.

Le transistor 300 comporte donc uniquement des espaceurs poreux 526a, 526b et présente ainsi une constante diélectrique qui correspond à celle des espaceurs poreux 526a, 526b, ce qui permet par exemple de réduire la constante diélectrique globale de la structure.

En résumé, le procédé de l'invention permet notamment des gravures anisotropes et la modification anisotrope réalisées de manière très sélective à un matériau semi-conducteur tel que le silicium. De plus, le procédé permet de former des espaceurs poreux et des espaceurs de protection tous présentant une constante diélectrique suffisamment faible, telle que celle du SiOCH poreux comprise entre 2.1 et 3 et celle du nitrure de silicium (SiN) de 7.

Le procédé de l'invention s'avère particulièrement avantageuse pour former les espaceurs de transistors de type MOSFET ou FinFET.

Le procédé de la présente invention permet de s'affranchir notamment des problèmes détaillés précédemment dans le cas où les espaceurs de la grille sont formés uniquement en nitrure de silicium, ces problèmes concernant par exemple la consommation excessive de silicium de la couche active, la formation de pieds au niveau des espaceurs de la grille à l'interface avec le substrat SOI tel que décrit en **figures 1b** **et** **1c** ainsi que l'érosion des espaceurs de la grille tel que décrit en **figure 1d****.**

Le procédé de la présente invention permet également de s'affranchir d'un autre problème détaillé ci-dessous de contrôle dimensionnel d'espaceurs poreux formés en un seul matériau de SiOCH poreux.

En effet, lors d'une exposition de ce matériau SiOCH poreux à un plasma de gravure en Argon et ce même avec un faible bombardement sur les flancs de la grille, le SiOCH poreux est modifié sur plusieurs nanomètres. Le SiOCH poreux modifié est ensuite consommé pendant l'étape de nettoyage HF tandis que le silicium de la couche active du substrat élaboré n'est pas consommé. La modification du SiOCH poreux rend ainsi difficile le contrôle du dimensionnel des espaceurs poreux de la grille.

Ainsi, l'utilisation combinée de deux matériaux formant deux espaceurs accolés, comprenant un espaceur de nitrure et un espaceur en diélectrique poreux 256, permet de pallier les problèmes ci-dessus. Les espaceurs de protection 152a, 152b protègent les espaceurs poreux 256a, 256b sur les flancs de la grille 120 lors de la réalisation des étapes du procédé de l'invention.

De plus, un transistor fabriqué par le procédé de la présente invention présente une capacité diminuée, ce qui permet ainsi d'augmenter la vitesse de fonctionnement du transistor et de réduire la consommation électrique des circuits. L'invention permet par conséquence d'améliorer la performance des transistors.

L'invention n'est pas limitée aux seuls modes et exemples de réalisation décrits ci-dessus, mais s'étend à tous les modes de réalisation entrant dans la portée des revendications.

## Revendications

1. Procédé de formation des espaceurs (152a, 152b, 256a, 256b) d'une grille (120) d'un transistor à effet de champ (200), la grille (120) étant située au dessus d'une couche active (146) en un matériau semi-conducteur surmontant une couche isolante (144) et un substrat de support (142), la couche active (146), la couche isolante (144) et le substrat de support (142) définissant un empilement de type silicium sur isolant (SOI), comprenant une étape (530) de formation d'une couche de protection (152) recouvrant au moins la grille (120) du transistor (200), le procédé étant **caractérisé en ce qu'**il comprend :
- avant l'étape de formation de la couche de protection (152), une étape de formation (520) d'une couche poreuse (256) entre la grille (120) et la couche de protection (152), la couche poreuse (256) présentant une constante diélectrique k égale ou inférieure à celle de l'oxyde de silicium (SiO2) ;
- après l'étape de formation de la couche de protection (152), une étape de gravure (540) de la couche de protection (152) réalisée de manière anisotrope de sorte à conserver des portions résiduelles (152a, 152b) de la couche de protection (152) uniquement au niveau des flancs de la grille (120), ces portions résiduelles (152a, 152b) constituant des espaceurs de protection (152a, 152b) de la grille (120) et de sorte à découvrir la couche poreuse (256) en dehors des flancs de la grille (120);
- une modification (550) de la couche poreuse (256) effectuée par pénétration d'ions au sein de la couche poreuse (256) pour former une couche modifiée (166), ladite modification (550) de la couche poreuse (256) étant effectuée à l'aide d'un plasma dont les ions pénètrent dans la couche poreuse découverte, ladite modification étant réalisée de manière anisotrope et de sorte à modifier la couche poreuse (256) sur toute son épaisseur au dessus de la grille (120) et au-dessus de la couche active (146) et de sorte à ne pas modifier toute l'épaisseur de la couche poreuse (256) située sur les flancs de la grille (120), la couche poreuse (256) située sur les flancs de la grille (120) étant protégée par les espaceurs de protection (152a, 152b) et constituant des espaceurs poreux (256a, 256b) pour la grille (120) ; et
- au moins une étape de retrait (560) de la couche modifiée (166) à l'aide d'une gravure sélective de la couche modifiée (166) vis-à-vis dudit matériau semi-conducteur de la couche active (146) et des espaceurs de protection (152a, 152b) protégeant la couche poreuse (256) située sur les flancs de la grille (120) et dans lequel,
la couche active (146) présente une épaisseur inférieure à 30nm et de préférence inférieure à 20nm,
la couche poreuse est disposée directement au contact de la couche active (146) et l'étape de formation (520) de la couche poreuse (256) est réalisée pour former une couche poreuse (256) dont l'épaisseur est inférieure à 20 nm.

2. Procédé selon la revendication précédente dans lequel l'étape de gravure (540) et la modification (550) sont effectuées au cours d'une seule étape au cours de laquelle les ions utilisés pour graver la couche de protection (152) modifient la couche poreuse (256) afin de former la couche modifiée (166).

3. Procédé selon l'une quelconque des revendications précédentes dans lequel le plasma utilisé pour la modification (550) de la couche poreuse (256) est à base d'argon (Ar), d'oxygène (O2) ou d'azote (N2).

4. Procédé selon l'une quelconque des revendications précédentes dans lequel l'étape de retrait (560) de la couche modifiée (166) est effectuée de manière à conserver la couche poreuse (256) sur les flancs de la grille (120).

5. Procédé selon l'une quelconque des revendications précédentes dans lequel de part et d'autre de la grille (120), la couche poreuse est disposée directement au contact de la couche active (146), dans lequel la modification (550) de la couche poreuse (256) effectuée à l'aide d'un plasma est réalisée de manière à implanter la couche poreuse de manière continue depuis la surface de la couche poreuse (256) par laquelle les ions du plasma pénètrent.

6. Procédé selon l'une quelconque des revendications précédentes dans lequel l'étape de modification réalisée à partir d'un plasma modifie la couche poreuse de manière continue depuis la surface de la couche poreuse (256) et sur toute l'épaisseur de la couche poreuse, l'épaisseur de la couche poreuse étant inférieure à 10 nm.

7. Procédé selon l'une quelconque des revendications précédentes, dans lequel la couche active (146) présente une épaisseur inférieure à 20nm.

8. Procédé selon l'une quelconque des revendications précédentes dans lequel la couche de protection (152) est une couche de nitrure de bore (BN), de SiO2, de SiOCH non poreux ou de SiCBN.

9. Procédé selon l'une quelconque des revendications précédentes dans lequel la couche poreuse (256) est une couche de SiOCH poreux et dans lequel la couche modifiée (166) est formée d'oxyde de silicium (SiO2) poreux.

10. Procédé selon l'une quelconque des revendications précédentes dans lequel l'étape de retrait (560) de la couche modifiée (166) est effectuée par gravure humide sélective audit matériau semi-conducteur de la couche active (146) et dans lequel le matériau semi-conducteur est du silicium et dans lequel l'étape de retrait (560) de la couche modifiée (166) est effectuée par gravure humide sélectivement au silicium (Si) à l'aide d'une solution à base d'acide fluorhydrique (HF).

11. Procédé selon l'une quelconque des revendications 1 à 9 dans lequel le matériau semi-conducteur est du silicium et dans lequel l'étape de retrait (560) de la couche modifiée (166) est effectuée par gravure sèche sélective au silicium (Si), la gravure sèche étant effectuée dans un plasma à base de trifluorure d'azote (NF3) et d'ammoniac (NH3) et dans lequel la gravure sèche comprend :
une étape de gravure (620) consistant en la formation de sels solides ;
une étape de sublimation (630) des espèces solides.

12. Procédé selon l'une quelconque des revendications précédentes dans lequel ladite modification (550) effectuée de sorte à modifier la couche poreuse (256) dans toute son épaisseur sur toutes les surfaces parallèles au plan d'un substrat sur lequel repose la grille (120) et à ne pas modifier la couche poreuse (256) dans toute son épaisseur sur les surfaces perpendiculaires à ce plan.

13. Procédé selon l'une quelconque des revendications précédentes, dans lequel le transistor est un transistor de type FDSOI ou de type FinFET.

## Patentansprüche

1. Verfahren zum Bilden der Abstandshalter (152a, 152b, 256a, 256b) eines Gates (120) eines Feldeffekttransistors (200), wobei das Gate (120) über einer aktiven Schicht (146) aus einem Halbleitermaterial liegt, die eine Isolierschicht (144) und ein Trägersubstrat (142) überdeckt, wobei die aktive Schicht (146), die Isolierschicht (144) und das Trägersubstrat (142) einen Stapel vom Typ Silicon-on-Isolator (SOI) definieren, umfassend einen Schritt (530) des Bildens einer Schutzschicht (152), die mindestens das Gate (120) des Transistors (200) bedeckt, wobei das Verfahren **dadurch gekennzeichnet ist, dass** es umfasst:
- vor dem Schritt des Bildens der Schutzschicht (152) einen Schritt des Bildens (520) einer porösen Schicht (256) zwischen dem Gate (120) und der Schutzschicht (152), wobei die poröse Schicht (256) eine Dielektrizitätskonstante k von gleich oder kleiner als derjenigen des Siliziumoxids (SiO2) aufweist;
- nach dem Schritt des Bildens der Schutzschicht (152) einen Schritt des Ätzens (540) der Schutzschicht (152), der anisotrop derart ausgeführt wird, dass Restabschnitte (152a, 152b) der Schutzschicht (152) nur im Bereich der Flanken des Gates (120) beibehalten werden, wobei diese Restabschnitte (152a, 152b) Schutz-Abstandshalter (152a, 152b) des Gates (120) darstellen, und derart, dass die poröse Schicht (256) außerhalb der Flanken des Gates (120) freigelegt wird;
- ein Modifizieren (550) der porösen Schicht (256), das durch loneneindringung innerhalb der porösen Schicht (256) durchgeführt wird, um eine modifizierte Schicht (166) zu bilden, wobei das Modifizieren (550) der porösen Schicht (256) mithilfe eines Plasmas durchgeführt wird, dessen Ionen in die freiliegende poröse Schicht eindringen, wobei das Modifizieren anisotrop und derart ausgeführt wird, dass die poröse Schicht (256) auf ihrer ganzen Dicke über dem Gate (120) und über der aktiven Schicht (146) modifiziert wird, und derart, dass die ganze Dicke der porösen Schicht (256), die an den Flanken des Gates (120) liegt, nicht modifiziert wird, wobei die poröse Schicht (256), die an den Flanken des Gates (120) liegt, von den Schutz-Abstandshalten (152a, 152) geschützt wird und poröse Abstandshalter (256a, 256b) für das Gate (120) darstellt; und
- mindestens einen Schritt des Entfernens (560) der modifizierten Schicht (166) mit Hilfe eines selektiven Ätzens der modifizierten Schicht (166) gegenüber dem Halbleitermaterial der aktiven Schicht (146) und der Schutz-Abstandshalter (152a, 152b), die die an den Flanken des Gates (120) liegende poröse Schicht (256) schützen, und wobei
die aktive Schicht (146) eine Dicke von weniger als 30 nm und vorzugsweise weniger als 20 nm aufweist,
die poröse Schicht direkt in Kontakt mit der aktiven Schicht (146) angeordnet wird und der Schritt des Bildens (520) der porösen Schicht (256) ausgeführt wird, um eine poröse Schicht (256) zu bilden, deren Dicke weniger als 20 nm beträgt.

2. Verfahren nach dem vorstehenden Anspruch, wobei der Schritt des Ätzens (540) und des Modifizierens (550) im Laufe eines einzigen Schritts durchgeführt werden, in dessen Verlauf die Ionen, die dafür verwendet werden, die Schutzschicht (152) zu ätzen, die poröse Schicht (256) modifizieren, um die modifizierte Schicht (166) zu bilden.

3. Verfahren nach einem der vorstehenden Ansprüche, wobei das Plasma, das dafür das Modifizieren (550) der porösen Schicht (256) verwendet wird, auf Basis von Argon (Ar), Sauerstoff (O2) oder Stickstoff (N2) ist.

4. Verfahren nach einem der vorstehenden Ansprüche, wobei der Schritt des Entfernens (560) der modifizierten Schicht (166) so durchgeführt wird, dass die poröse Schicht (256) an den Flanken des Gates (120) beibehalten wird.

5. Verfahren nach einem der vorstehenden Ansprüche, wobei die poröse Schicht auf beiden Seiten des Gates (120) direkt in Kontakt mit der aktiven Schicht (146) angeordnet wird, wobei das Modifizieren (550) der porösen Schicht (256), das mithilfe eines Plasmas durchgeführt wird, so ausgeführt wird, dass die poröse Schicht ab der Oberfläche der porösen Schicht (256), durch die die Ionen des Plasmas eindringen, kontinuierlich implantiert wird.

6. Verfahren nach einem der vorstehenden Ansprüche, wobei der Schritt des Modifizierens, der auf Grundlage eines Plasmas ausgeführt wird, die poröse Schicht ab der Oberfläche der porösen Schicht (256) und auf der ganzen Dicke der porösen Schicht kontinuierlich modifiziert, wobei die Dicke der porösen Schicht weniger als 10 nm beträgt.

7. Verfahren nach einem der vorstehenden Ansprüche, wobei die aktive Schicht (146) eine Dicke von weniger als 20 nm aufweist.

8. Verfahren nach einem der vorstehenden Ansprüche, wobei die Schutzschicht (152) eine Schicht aus Bornitrit (BN), aus SiO2, aus nicht porösem SiOCH oder aus SiCBN ist.

9. Verfahren nach einem der vorstehenden Ansprüche, wobei die poröse Schicht (256) eine Schicht aus porösem SiOCH ist, und wobei die modifizierte Schicht (166) aus porösem Siliziumoxid (SiO2) gebildet ist.

10. Verfahren nach einem der vorstehenden Ansprüche, wobei der Schritt des Entfernens (560) der modifizierten Schicht (166) durch für das Halbleitermaterial der aktiven Schicht (146) selektives Nassätzen durchgeführt wird, und wobei das Halbleitermaterial Silizium ist und wobei der Schritt des Entfernens (560) der modifizierten Schicht (166) durch für das Silizium (Si) selektives Nassätzen mithilfe einer Lösung auf Basis von Fluorwasserstoffsäure (HF) durchgeführt wird.

11. Verfahren nach einem der Ansprüche 1 bis 9, wobei das Halbleitermaterial Silizium ist, und wobei der Schritt des Entfernens (560) der modifizierten Schicht (166) durch für das Silizium (Si) selektives Trockenätzen durchgeführt wird, wobei das Trockenätzen in einem Plasma auf Basis von Stickstofftrifluorid (NF3) und Ammoniak (NH3) durchgeführt wird, und wobei das Trockenätzen umfasst:
einen Schritt des Ätzens (620), der in der Bildung von festen Salzen besteht;
einen Schritt des Sublimierens (630) der festen Stoffe.

12. Verfahren nach einem der vorstehenden Ansprüche, wobei das Modifizieren (550) derart durchgeführt, dass die poröse Schicht (256) in ihrer ganzen Dicke an allen den Oberflächen, die zur Ebene eines Substrats, auf dem das Gate (120) ruht, parallel sind, modifiziert wird, und dass die poröse Schicht (256) in ihrer ganzen Dicke an den Oberflächen, die zu dieser Ebene senkrecht sind, nicht modifiziert wird.

13. Verfahren nach einem der vorstehenden Ansprüche, wobei der Transistor ein Transistor vom Typ FDSOI oder vom Typ FinFET ist.

## Claims

1. Method for forming spacers (152a, 152b, 256a, 256b) of a gate (120) of a field effect transistor (200), the gate (120) being located above an active layer (146) made of a semi-conductive material surmounting an insulating layer (144) and a support substrate (142), the active layer (146), the insulating layer (144) and the support substrate (142) defining a silicon-on-insulator (SOI)-type stack, comprising a step (530) of forming a protective layer (152) covering at least the gate (120) of the transistor (200), the method being **characterised in that** it comprises:
- before the step of forming the protective layer (152), a step of forming (520) a porous layer (256) between the gate (120) and the protective layer (152), the porous layer (256) having a dielectric constant k equal to or less than that of silicon oxide (SiO₂);
- after the step of forming the protective layer (152), a step of etching (540) the protective layer (152) produced anisotropically, so as to conserve residual portions (152a, 152b) of the protective layer (152) only at the level of the edges of the gate (120), these residual portions (152a, 152b) constituting protective spacers (152a, 152b) of the gate (120) and so as to uncover the porous layer (256) outside of the edges of the gate (120);
- a modification (550) of the porous layer (256) carried out by penetrating ions within the porous layer (256) to form a modified layer (166), said modification (550) of the porous layer (256) being carried out using a plasma, of which the ions penetrate into the porous layer uncovered, said modification being carried out anisotropically and so as to modify the porous layer (256) over the whole of the thickness thereof above the gate (120) and above the active layer (146) and so as to not modify the whole thickness of the porous layer (256) located on the edges of the gate (120), the porous layer (256) located on the edges of the gate (120) being protected by the protective spacers (152a, 152b) and constituting porous spacers (256a, 256b) for the gate (120); and
- at least one step of removing (560) the modified layer (166) using a selective etching of the modified layer (166) opposite said semi-conductive material of the active layer (146) and protective spacers (152a, 152b) protecting the porous layer (256) located on the edges of the gate (120) and wherein,
the active layer (146) has a thickness less than 30nm and preferably less than 20nm,
the porous layer is arranged directly in contact with the active layer (146) and the step of forming (520) the porous layer (256) is carried out to form a porous layer (256) of which the thickness is less than 20nm.

2. Method according to the preceding claim, where the etching (540) and modification (550) step are carried out during one single step during which the ions used to etch the protective layer (152) modify the porous layer (256) in order to form the modified layer (166).

3. Method according to any one of the preceding claims, wherein the plasma used to modify (550) the porous layer (256) is argon (Ar), oxygen (O₂) or nitrogen (N₂)-based.

4. Method according to any one of the preceding claims, wherein the step of removing (560) the modified layer (166) is carried out so as to conserve the porous layer (256) on the edges of the gate (120).

5. Method according to any one of the preceding claims, wherein on either side of the gate (120), the porous layer is arranged directly in contact with the active layer (146), wherein the modification (550) of the porous layer (256) carried out using a plasma is carried out so as to implant the porous layer continuously from the surface of the porous layer (256) by which the ions of the plasma penetrate.

6. Method according to any one of the preceding claims, wherein the modification step carried out from a plasma modifies the porous layer continuously from the surface of the porous layer (256) and over the whole thickness of the porous layer, the thickness of the porous layer being less than 10nm.

7. Method according to any one of the preceding claims, wherein the active layer (146) has a thickness of less than 20nm.

8. Method according to any one of the preceding claims, wherein the protective layer (152) is a boron nitride (BN), SiO₂, non-porous SiOCH or SiCBN layer.

9. Method according to any one of the preceding claims, wherein the porous layer (256) is a porous SiOCH layer and wherein the modified layer (166) is formed of porous silicon oxide (SiO₂).

10. Method according to any one of the preceding claims, wherein the step of removing (560) the modified layer (166) is carried out by selective wet etching said semi-conductive material of the active layer (146) and wherein the semi-conductive material is silicon and wherein the step of removing (560) the modified layer (166) is carried out by wet etching selectively with silicon (Si) using a hydrofluoric (HF) acid-based solution.

11. Method according to any one of claims 1 to 9, wherein the semi-conductive material is silicon and wherein the step of removing (560) the modified layer (166) is carried out by selective dry etching with silicon (Si), the dry etching being carried out in a nitrogen trifluoride (NF₃) and ammoniac (NH₃)-based plasma and wherein the dry etching comprises:
- an etching step (620) consisting of the formation of solid salts;
- a step of subliming (630) solid species.

12. Method according to any one of the preceding claims, wherein said modification (550) carried out so as to modify the porous layer (256) in the whole of the thickness thereof over all the surfaces parallel to the plane of a substrate on which the gate (120) rests, and to not modify the porous layer (256) in the whole of the thickness thereof on the surfaces perpendicular to this plane.

13. Method according to any one of the preceding claims, wherein the transistor is an FDSOI or FinFET-type transistor.
